(19) Europäisches Patentamt
European Patent Office
Office européen des brevets

(11) **EP 2 267 886 A1**

(12) **EUROPEAN PATENT APPLICATION**

(43) Date of publication:
**29.12.2010 Bulletin 2010/52**

(51) Int Cl.:
**H03F 3/217** *(2006.01)*     **H03F 3/191** *(2006.01)*

(21) Application number: **09360034.4**

(22) Date of filing: **11.06.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(71) Applicant: **Alcatel Lucent**
**75008 Paris (FR)**

(72) Inventor: **Grebennikov, Andrei**
**Castleknock**
**Dublin 15 (IE)**

(74) Representative: **Coghlan, Judith Elizabeth Kensy et al**
**Bryer, Shelley, John Amor, Greenwood LLP**
**7 Gay Street**
**Bath BA1 2PH (GB)**

Remarks:
Amended claims in accordance with Rule 137(2) EPC.

(54) **Class E amplifier**

(57)     A class E amplifier operates to amplify an input signal having a fundamental frequency in the microwave range. The amplifier comprises a component circuit which operates to selectively deliver an output signal to an output load. The output signal has a frequency substantially identical to the fundamental frequency of the input signal.

The component circuit comprises an array of transmission lines having selected electrical lengths that provide a load to the output load at the fundamental frequency, provide substantially infinite impedance between the input signal and the output load at a second harmonic frequency, and provide substantially infinite impedance between the input signal and the output load at a third harmonic frequency.

FIG. 2

## Description

### FIELD OF THE INVENTION

The present invention relates to a class E amplifier.

### BACKGROUND

Class E amplifiers are known. In wireless telecommunications systems it is sometimes required to provide and utilise power amplifiers. In such arrangements, it is desired to use power amplifiers capable of operating with high efficiency and linearity whilst maintaining a low harmonic level. A switching-mode class E amplifier is a particularly efficient power amplifier. It has been found that at high frequencies a parallel circuit class E load network amplifier can significantly improve amplifier efficiency. Such an arrangement operates in saturation mode and thus results in poor linearity and consequently cannot be used to directly replace linear power amplifiers in conventional WCDMA (Wideband Code Division Multiple Access) transmitters using a non-constant envelope signal.

Although existing class E amplifier implementations exist, they each have undesirable characteristics which reduce their operating efficiency and allow undesirable harmonic signals to reach their output signals.

It is desired to provide an improved class E amplifier.

### SUMMARY

According to a first aspect there is provided a class E amplifier operable to amplify an input signal having a fundamental frequency in the microwave range, comprising:

a component circuit operable to selectively deliver an output signal to an output load, that output signal having a frequency substantially identical to the fundamental frequency,
the component circuit comprising:

an array of transmission lines having selected electrical lengths to:
provide a load to the output load at the fundamental frequency provide substantially infinite impedance between the input signal and the output load at a second harmonic frequency, and provide substantially infinite impedance between the input signal and the output load at a third harmonic frequency.

The first aspect recognises that in known class E amplifiers, load matching is provided at the fundamental frequency, but the impedance characteristics of the amplifier at the harmonics typically remain unspecified, resulting in efficiency degradation. Providing significant harmonic suppression at the amplifier output typically requires use of a harmonic filter which increases cost and size of an amplifier system.

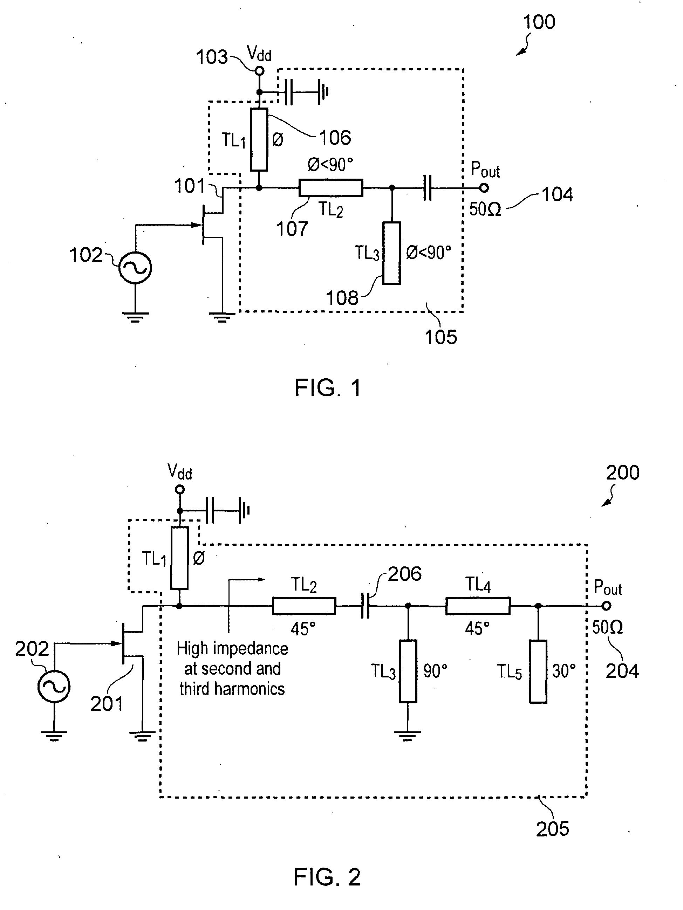

A known class E amplifier is shown in Figure 1. In this arrangement, a class E amplifier circuit 100 comprises a transistor 101 responsive to an input signal from an input source 102, a dc power source 103, an output load 104 and a load network 105. The load network 105 comprises a short-length, short circuited parallel microstrip transmission line 106 and an output load matching network comprising a series microstrip transmission line 107 and a shunt microstrip transmission line stub 108, representing a low-pass L-type matching section.

The shunt microstrip transmission line stub 108 is arranged such that it creates a capacitive reactance in the instance of an input signal with a predetermined fundamental frequency. That capacitative reactance can be provided by ensuring that the stub 108 is arranged in an open circuit condition with an effective electrical length of less than 90 degrees, or arranged in a closed circuit condition with an effective electrical length of more than 90 degrees.

Improved class E operation of the known amplifier shown in Figure 1 is typically obtained by also allowing for the internal capacitance of the transistor 101.

Accordingly, the present aspect provides an amplifier having a component circuit comprising an array of transmission lines having effective electrical lengths selected such that the amplifier operates to minimise the main harmonic frequencies reaching the output load, and enables provision of a more efficient amplifier.

In one embodiment, the array comprises two primary transmission lines of predetermined length, the at least two primary transmission lines together providing the load to the output load at the fundamental frequency and the substantially infinite impedances at said second and third harmonic frequencies.

A combination of two or more primary transmission lines may be provided which together may be used to provide substantially infinite impedances at the second and third harmonic frequencies.

In one embodiment, the two primary transmission lines are arranged in series in the array of transmission lines.

The primary transmission lines are provided in series between an amplifier input, which receives the input signal, and the output load.

In one embodiment, the array further comprises a first transmission line stub, the primary transmission lines and first transmission line stub together providing the load to the output load at the fundamental frequency and the substantially infinite impedance at the second and third harmonic frequencies.

A first transmission line stub may allow the properties of the transmission line array to be created using the primary transmission lines and the additional stub. The properties of the array can thus be modified by the addition of the first transmission line stub.

In one embodiment, the array further comprises a second transmission line stub, the primary transmission lines and first and second transmission line stubs together providing the load to the output load at the fundamental frequency and the substantially infinite impedance at the second and third harmonic frequencies.

A second transmission line stub may allow the properties of the transmission line array to be created using the primary transmission lines and the additional stubs. The properties of the array can thus be modified by the addition of the second transmission line stub.

In one embodiment, one of the first and second transmission line stubs is provided between the primary transmission lines and the other of the first and second transmission line stubs is provided between the primary transmission lines and the output load.

Such an arrangement allows simple addition of first and second transmission line stubs to the transmission line array. In particular, the first and second transmission line stubs may help to provide all or some of the conditions required to provide the substantially infinite impedance at the second and third harmonic frequencies.

In one embodiment, the transmission line stub provided between the primary transmission lines has an electrical length of substantially 90 degrees at said fundamental frequency, and the transmission line stub provided between said primary transmission lines and said output load has an electrical length of substantially 30 degrees at said fundamental frequency.

In one embodiment, the one of the first and second transmission line stubs provided between the primary transmission lines and the output load is arranged in an open circuit condition.

In one embodiment, the one of the first and second transmission line stubs provided between the primary transmission lines is arranged in a closed circuit condition.

Arranging the transmission line stubs to match the conditions as described above allows one transmission line stub to effectively provide part of the load at the fundamental frequency provided to the output load, and zero impedance at a third harmonic, and one transmission line stub which provides effectively infinite impedance at the fundamental and third harmonic frequencies and substantially zero impedance at the second harmonic frequency.

In one embodiment, the primary transmission lines together provide an effective electrical length at the fundamental frequency of substantially 90 degrees.

Accordingly, the primary transmission lines may offer substantially zero impedance at the fundamental frequency.

In one embodiment, one of the primary transmission lines provides an effective electrical length at the fundamental frequency of substantially 45 degrees.

Such an arrangement allows the primary transmission line providing an effective electrical length of 45 degrees at the fundamental frequency to provide, in conjunction with another primary transmission line, substantially zero impedance at the fundamental frequency, to provide itself a substantially infinite impedance at the second harmonic frequency, and to contribute to the provision of substantially infinite impedance at the third harmonic frequency.

In one embodiment, each of the primary transmission lines provides an effective electrical length at the fundamental frequency of substantially 45 degrees.

In one embodiment, the load provided to the output load at the fundamental frequency is matched to the output load.

Typically the transmission line array and component circuit together provide a load matched to the output load at the fundamental frequency. Matching the load to the output load ensures efficient operation of the amplifier. The transmission line array may provide a load complex conjugate load matched to the output load.

A second aspect provides a method of providing a class E amplifier operable to amplify an input signal having a fundamental frequency in the microwave range, comprising:

providing a component circuit operable to selectively deliver an output signal to an output load, that output signal having a frequency substantially identical to the fundamental frequency, said component circuit comprising an array of transmission lines, and selecting electrical lengths of the transmission lines forming the array to:

provide a load to the output load at the fundamental frequency provide substantially infinite impedance between the input signal and the output load at a second harmonic frequency, and provide substantially infinite impedance between the input signal and the output load at a third harmonic frequency.

In one embodiment, the method further comprises the step of providing at least two primary transmission lines of predetermined length, the at least two primary transmission lines together providing the load to the output load at the fundamental frequency and the substantial infinite impedances at the second and third harmonic frequencies.

In one embodiment, the method further comprises the step of arranging the at least two primary transmission lines in series in the array of transmission lines.

In one embodiment, the method further comprises the step of providing the array with a first transmission line stub, the primary transmission lines and first transmission line stub together providing the load to the output load at the fundamental frequency and the substantially infinite impedance at said second and third harmonic frequencies.

In one embodiment the method further comprises the step of providing a second transmission line stub, the primary transmission lines and first and second transmission line stubs together providing the load to the output load at the fundamental frequency and the substantially infinite impedance at said second and third harmonic frequencies.

In one embodiment, the method further comprises the steps of providing one of the first and second transmission line stubs between the primary transmission lines and providing the other of the first and second transmission line stubs between the primary transmission lines and the output load.

In one embodiment the method further comprises the step of selecting an electrical length of substantially 90 degrees at said fundamental frequency for the transmission line stub provided between the primary transmission lines, selecting an electrical length of substantially 30 degrees at said fundamental frequency for the transmission line stub provided between the primary transmission lines and the output load.

In one embodiment, the method further comprises the step of arranging the one of the first and second transmission line stubs provided between the primary transmission lines and the output load in an open circuit condition.

In one embodiment, the method further comprises the step of arranging the one of the first and second transmission line stubs provided between the primary transmission lines in a closed circuit condition.

In one embodiment, the method further comprises the step of providing the primary transmission lines such that they together provide an effective electrical length at the fundamental frequency of substantially 90 degrees.

In one embodiment, the method further comprises the step of selecting one of the primary transmission lines to provide an effective electrical length at the fundamental frequency of substantially 45 degrees.

In one embodiment, the method further comprises the step of selecting each of the primary transmission lines to provide an effective electrical length at the fundamental frequency of substantially 45 degrees.

In one embodiment, the method further comprises the step of matching the load provided to the output load at the fundamental frequency to the output load.

Further particular and preferred aspects are set out in the accompanying independent and dependent claims. Features of the dependent claims may be combined with the features of the independent claims as appropriate and in combinations other than those explicitly set out in the claims.

BRIEF DESCRIPTION OF THE DRAWINGS

Embodiments of the present invention will now be described further, with reference to the accompanying drawings, in which:

Figure 1 illustrates schematically a known arrangement of a class E amplifier;
Figure 2 illustrates schematically a class E amplifier arranged in accordance with one embodiment,
Figures 3a to 3c show the effective circuit formed by the amplifier arrangement of
Figure 2 at the fundamental, second and third harmonic frequencies;

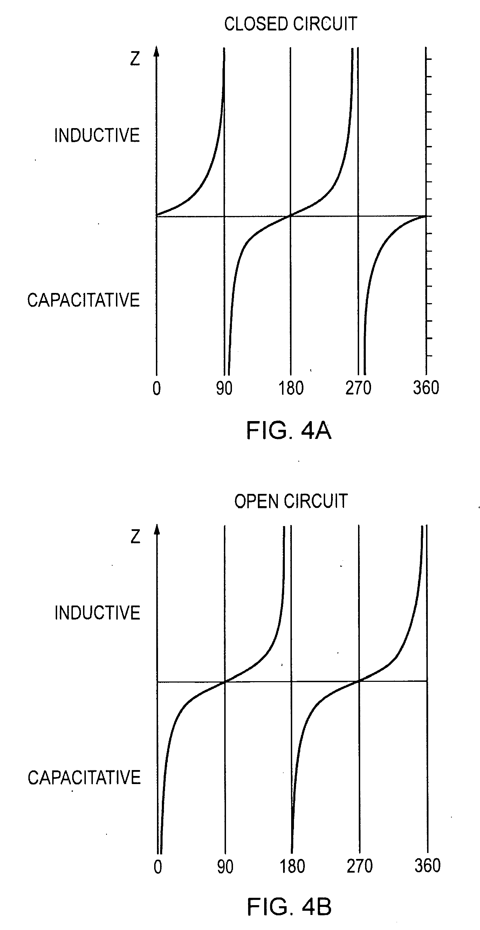

Figures 4a and 4b illustrate the impedance characteristics of transmission lines of differing electrical lengths in both open-circuit and a closed-circuit arrangements; and

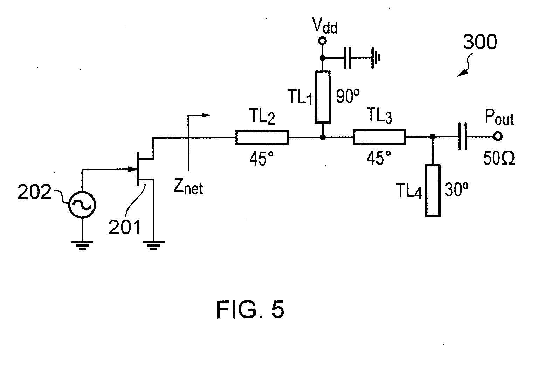

Figure 5 illustrates schematically a class E amplifier arranged in accordance with a second embodiment.

DESCRIPTION OF THE EMBODIMENTS

Electronic amplifiers are used in wireless communications networks, typically in user equipment, for example, mobile telephone handsets, and at base stations. Electronic amplifiers act to amplify signals to be transmitted. Use of efficient electronic amplifiers can assist in providing an improvement to the efficiency of the whole communication system. Use of an appropriately chosen electronic amplifier can result, for example, in lower power consumption and a consequent gain in battery life.

Figure 1 illustrates schematically a known arrangement of a class E amplifier, as described previously. In the arrangement shown in Figure 1, a low-pass matching load network circuit provides a load complex-conjugate matched with a 50 Ohm load at the fundamental frequency. The method of providing a load complex-conjugate matched to an output load will be well known to those skilled in the art. In respect of the arrangement shown in Figure 1 the method of providing a load complex-conjugate matched to the output load is fully described in US Patent No 6,552,210, the contents of which are incorporated herein by reference.

In the arrangement shown in Figure 1 the impedance conditions at the harmonics are not specified, which results in a loss in the potential efficiency which may be achieved by the amplifier. As will be understood, the main losses due to harmonic frequencies will be seen in the primary harmonics, i.e. the second and third harmonic frequencies.

Figure 2 illustrates schematically a class E amplifier arranged in accordance with one embodiment. The arrangement shown utilises and array of transmission-lines to provide a power amplifier with low harmonic level using a parallel-circuit Class E mode. The arrangement shown provides complex-conjugate load matching at the fundamental frequency and high impedances at the device output at the second and third harmonics. Use of an array of appropriately selected transmission lines, rather than lumped elements, is particularly effective at the microwave frequencies typically used in a wireless communications network.

The amplifier 200 shown in Figure 2 comprises a transistor 201 responsive to an input signal from an input source 202, a dc power source $V_{dd}$, an output load 204 of 50 Ohms and an array of transmission lines 205.

The array of transmission lines 205 comprises: a short circuited parallel transmission line $TL_1$ having an electrical length of $\theta$ at a fundamental frequency of a signal generated by the input source 202, two primary transmission lines $TL_2$ and $TL_4$, connected in series and each having an effective electrical length of 45 degrees at the fundamental frequency, an earthed transmission line stub $TL_3$ connected in parallel between the two primary transmission lines $TL_2$ and $TL_4$, transmission line stub $TL_3$ having an effective electrical length of 90 degrees at the fundamental frequency and , and an open circuit transmission line stub $TL_5$ connected in parallel between the two primary transmission lines $TL_2$ and $TL_4$ and the output load 204. Transmission line stub $TL_5$ is selected to have an effective electrical length of 30 degrees at the fundamental frequency. The transmission line array 205 further comprises a capacitor 206 arranged in series at the end of transmission line $TL_2$ which acts as a blocking capacitor by blocking dc from the power source $V_{dd}$, thereby isolating the dc bias path from the microwave frequency path.

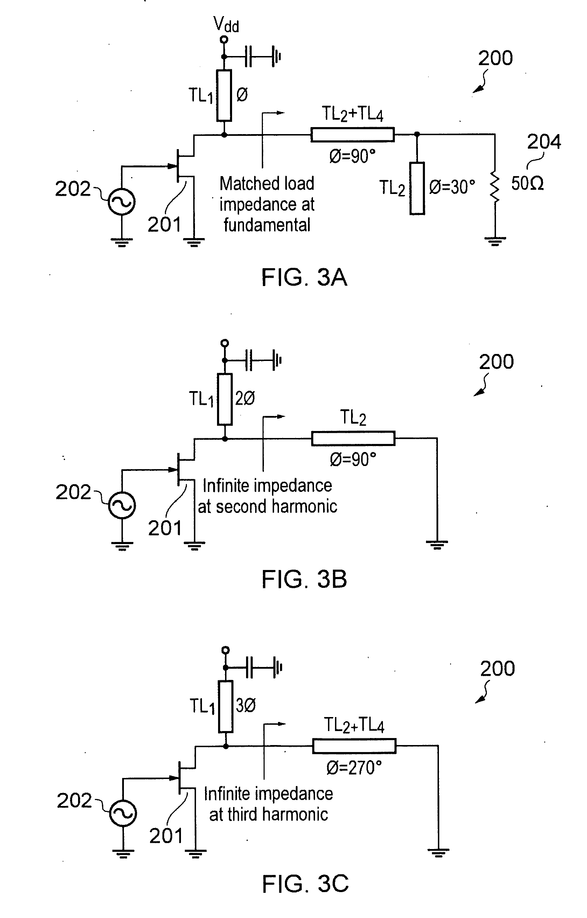

Figures 3a to 3c show the effective circuit formed by the amplifier arrangement of Figure 2 at the fundamental, second and third harmonic frequencies respectively.

Figure 3(a) shows the effective component circuit seen at the fundamental frequency.

Using the schematic graphs shown in Figures 4a and 4b, which illustrate the impedance characteristics of transmission lines of differing electrical lengths in both open-circuit and a closed-circuit arrangements, it is possible to predict the effective component circuit at each frequency. At the fundamental frequency, transmission line stub $TL_3$ having an effective electrical length of 90 degrees in a closed circuit condition, has an effectively infinite impedance and is thus not seen.

The two primary transmission lines $TL_2$ and $TL_4$, connected in series and each having an effective electrical length of 45 degrees at the fundamental frequency, together effectively form a transmission line having an effective electrical length of 90 degrees. The primary transmission lines thus form a series quarterwave line ($TL_2 + TL_4$). At the fundamental frequency, in the open circuit condition as shown, the quarter wave line has a substantially zero impedance (see Fig 4b).

Open-circuit stub $TL_5$, with electrical length of 30 degrees behaves as a capacitance at the fundamental frequency (see Fig 4b) and contributes to provision of an impedance matched to the load 204. The quarterwave transmission line ($TL_2 + TL_4$) transforms the capacitive load impedance (formed from the output load resistance and equivalent capacitance of the 30 degree open-circuit stub) into a inductive impedance seen at the output of the amplifier 200.

At microwave frequencies, the device output capacitance typically exceeds the required optimum Class E value, but arranging a transmission line array as shown in Figure 3a enables creation of an inductive input reactance as described above. That inductive input reactance can match the optimum Class E load resistance with a standard 50-Ohm load (typical in wireless communication network systems) and to compensate for the capacitive device output reactance caused by amplifier drain-source capacitance.

To provide optimum parallel-circuit Class E mode operation, the electrical length of shunt transmission line $TL_1$ is be chosen according to the equation

$$\theta = \arctan(0.732R/Z_0)$$

where Zo is the transmission-line characteristic impedance (usually between 25 Ohm and 75 Ohm), and R = $1.365(V_{dd})2/P_{out}$, where $V_{dd}$ is the supply voltage, and Pout is the output power.

Figure 3b illustrates schematically the effective component circuit load seen at the second harmonic. At the second harmonic frequency, transmission line $TL_3$, has an effective electrical length of 180 degrees (half a wavelength) in a closed circuit condition and thus provides a substantially zero impedance (see Fig 4a). As a consequence, this provides a shorting of transmission line $TL_2$. At the second harmonic frequency, $TL_2$ has an effective electrical length of 90 degrees (a quarter wavelength) and is now arranged (via $TL_3$) in a closed circuit condition, and thus provides substantially infinite impedance (see Fig 4a) at the second harmonic frequency.

Figure 3c illustrates schematically the effective component circuit load seen at the third harmonic. At the third harmonic frequency, transmission line $TL_3$ has an effective electrical length of 270 degrees. In accordance with the closed circuit relationship illustrated in Figure 4a, $TL_3$ provides an approximately infinite impedance at its input.

At the third harmonic frequency, open-circuit stub $TL_5$ has an effective electrical length of 90 degrees (a quarter wavelength). In accordance with the relationship shown in Figure 4b, open-circuit stub $TL_5$ thus provides substantially zero impedance at its input. As a result, the resulting component circuit comprises a short-circuited transmission line ($TL_2 + TL_4$) which, at the third harmonic has an effective electrical length of 270 degrees in a closed circuit configuration which provides a high impedance seen by the device output.

Amplifier output parasitic reactances can thus be minimised by selecting the lengths of the series transmission lines $TL_2$ and $TL_4$ to provide high impedance conditions at the second and third harmonics.

Figure 5 illustrates schematically a class E amplifier arranged in accordance with a second embodiment. Figure 5 illustrates a similar amplifier arrangement, in this case, a conventional class E configuration with a shunt capacitance. Identical reference numerals and letters have been used as appropriate. In the arrangement shown in Figure 5 the component circuit provides Class E impedance conditions at the fundamental frequency and infinite impedance conditions at the second and third harmonics in an analogous manner to that described above.

At the fundamental frequency, however, the optimum inductive impedance at the fundamental frequency is defined according to

$$Z_{net}(f_0) = R(1 + j\tan 49.052°)$$

where $R = 0.5768(V_{dd})2/P_{out}$
[T. B. Mader and Z. B. Popovic, "The Transmission-Line High-Efficiency Class-E Amplifier," IEEE Microwave and Guided Wave Lett., vol. 5, pp. 290-292, Sept. 1995].

It will be appreciated that the required impedance characteristics of the transm ission lines may be achieved by utilising transmission lines of different lengths in an appropriate open or closed circuit configuration.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

It should be appreciated by those skilled in the art that any block diagrams herein represent conceptual views of illustrative circuitry embodying the principles of the invention.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

**Claims**

1. A class E amplifier operable to amplify an input signal having a fundamental frequency in the microwave range, comprising:

   a component circuit operable to selectively deliver an output signal to an output load, that output signal having a frequency substantially identical to the fundamental frequency, said component circuit comprising:

   an array of transmission lines having selected electrical lengths to:

   provide a load to the output load at the fundamental frequency provide substantially infinite impedance between the input signal and the output load at a second harmonic frequency, and provide substantially infinite impedance between the input signal and the output load at a third harmonic frequency.

2. A class E amplifier according to claim 1, wherein said array comprises at least two primary transmission lines of predetermined length, said at least two primary transmission lines together providing the load to the output load at the fundamental frequency and said substantial infinite impedances at said second and third harmonic frequencies.

3. A class E amplifier according to claim 2, wherein said at least two primary transmission lines are arranged in series in said array of transmission lines.

4. A class E amplifier according to claim 2 or claim 3, wherein said array further comprises a first transmission line stub, said primary transmission lines and first transmission line stub together providing said load to the output load at the fundamental frequency and said substantially infinite impedance at said second and third harmonic frequencies.

5. A class E amplifier according to claim 4, wherein said array further comprises a second transmission line stub, said primary transmission lines and first and second transmission line stubs together providing said load to the output load at the fundamental frequency and said substantially infinite impedance at said second and third harmonic frequencies.

6. A class E amplifier according to claim 5, wherein one of said first and second transmission line stubs is provided between said primary transmission lines and the other of said first and second transmission line stubs is provided between said primary transmission lines and said output load.

7. A class E amplifier according to claim 6, wherein said transmission line stub provided between said primary transmission lines has an electrical length of substantially 90 degrees at said fundamental frequency, and the transmission line stub provided between said primary transmission lines and said output load has an electrical length of substantially 30 degrees at said fundamental frequency.

8. A class E amplifier according to wherein the one of said first and second transmission line stubs provided between said primary transmission lines and said output load is arranged in an open circuit condition.

9. A class E amplifier according to claim 7 or claim 8, wherein the one of said first and second transmission line stubs provided between said primary transmission lines is arranged in a closed circuit condition.

10. A class E amplifier according to any one of claims 2 to 9, wherein said primary transmission lines together provide an effective electrical length at the fundamental frequency of substantially 90 degrees.

11. A class E amplifier according to claim 10, wherein one of said primary transmission lines provides an effective electrical length at the fundamental frequency of substantially 45 degrees.

12. A class E amplifier according to claim 10, wherein each of said primary transmission lines provides an effective electrical length at the fundamental frequency of substantially 45 degrees.

13. A class E amplifier according to any preceding claim, wherein the load provided to the output load at the fundamental frequency is matched to the output load.

14. A method of providing a class E amplifier operable to amplify an input signal having a fundamental frequency in the microwave range, comprising:

   providing a component circuit operable to selectively deliver an output signal to an output load, that output signal having a frequency substantially identical to the fundamental frequency, said component circuit comprising an array of transmission lines, and selecting electrical lengths of the transmission lines forming the array to:

      provide a load to the output load at the fundamental frequency provide substantially infinite impedance between the input signal and the output load at a second harmonic frequency, and
provide substantially infinite impedance between the input signal and the output load at a third harmonic frequency.

**Amended claims in accordance with Rule 137(2) EPC.**

1. A class E amplifier operable to amplify an input signal having a fundamental frequency in the microwave range, comprising:

   a component circuit operable to selectively deliver an output signal to an output load, that output signal having a frequency substantially identical to the fundamental frequency,
   said component circuit comprising:

      an array of transmission lines at least two primary transmission lines ($TL_2$, $TL_4$) of predetermined length, arranged in series in said array of transmission lines; a first transmission line stub ($TL_3$), and a second transmission line stub ($TL_5$), wherein one of said first and second transmission line stubs ($TL_3$, $TL_5$) is provided between said primary transmission lines and the other of said first and second transmission line stubs ($TL_3$, $TL_5$) is provided between said primary transmission lines and said output load, and wherein said transmission line stub ($TL_3$) provided between said primary transmission lines ($TL_2$, $TL_4$) has an electrical length of substantially 90 degrees at said fundamental frequency, and said transmission line stub ($TL_5$) provided between said primary transmission lines and said output load has an electrical length of substantially 30 degrees at said fundamental frequency; the array of transmission lines having selected electrical lengths to:

         provide an output load matching network to the output load at the fundamental frequency;
         provide substantially infinite impedance between the input signal and the output load at a second harmonic frequency; and
         provide substantially infinite impedance between the input signal and the output load at a third harmonic frequency.

2. A class E amplifier according to claim 1, wherein the one of said first and second transmission line stubs (TL$_5$) provided between said primary transmission lines (TL$_2$, TL$_4$) and said output load is arranged in an open circuit condition.

**3.** A class E amplifier according to claim 2, wherein the one of said first and second transmission line stubs (TL$_3$, TL$_5$) provided between said primary transmission lines is earthed.

**4.** A class E amplifier according to any preceding claim, wherein said primary transmission lines (TL$_2$, TL$_4$) together provide an effective electrical length at the fundamental frequency of substantially 90 degrees.

**5.** A class E amplifier according to claim 4, wherein one of said primary transmission lines (TL$_2$, TL$_4$) provides an effective electrical length at the fundamental frequency of substantially 45 degrees.

**6.** A class E amplifier according to claim 5, wherein each of said primary transmission lines (TL$_2$, TL$_4$) provides an effective electrical length at the fundamental frequency of substantially 45 degrees.

**7.** A class E amplifier according to any preceding claim, wherein said array of transmission lines is arranged to use a parallel-circuit class E mode.

**8.** A class E amplifier according to any preceding claim, wherein said output load matching network is complex conjugate load matching to said output load.

**9.** A method of providing a class E amplifier operable to amplify an input signal having a fundamental frequency in the microwave range, comprising:

providing a component circuit operable to selectively deliver an output signal to an output load, that output signal having a frequency substantially identical to the fundamental frequency, said component circuit comprising an array of transmission lines at least two primary transmission lines (TL$_2$, TL$_4$) of predetermined length, arranged in series in said array of transmission lines; a first transmission line stub (TL$_3$), and a second transmission line stub (TL$_5$), wherein one of said first and second transmission line stubs (TL$_3$, TL$_5$) is provided between said primary transmission lines and the other of said first and second transmission line stubs (TL$_3$, TL$_5$) is provided between said primary transmission lines and said output load, and wherein said transmission line stub (TL$_3$) provided between said primary transmission lines (TL$_2$, TL$_4$) has an electrical length of substantially 90 degrees at said fundamental frequency, and said transmission line stub (TL$_5$) provided between said primary transmission lines and said output load has an electrical length of substantially 30 degrees at said fundamental frequency;
and selecting electrical lengths of the transmission lines forming the array to:

provide a load to the output load at the fundamental frequency provide substantially infinite impedance between the input signal and the output load at a second harmonic frequency, and
provide substantially infinite impedance between the input signal and the output load at a third harmonic frequency.

FIG. 1

FIG. 2

FIG. 3A

FIG. 3B

FIG. 3C

CLOSED CIRCUIT

FIG. 4A

OPEN CIRCUIT

FIG. 4B

FIG. 5

EUROPEAN SEARCH REPORT

Application Number

EP 09 36 0034

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | AFLAKI P ET AL: "Novel Compact Transmission-line Output Network Topology for Class-E Power Amplifiers" MICROWAVE CONFERENCE, 2008. EUMC 2008. 38TH EUROPEAN, IEEE, PISCATAWAY, NJ, USA, 27 October 2008 (2008-10-27), pages 238-241, XP031407139 ISBN: 978-2-87487-006-4 * the whole document * | 1-14 | INV. H03F3/217 H03F3/191 |
| X | HAN GIL BAE ET AL: "High-efficiency GaN class-E power amplifier with compact harmonic-suppression network" MICROWAVE INTEGRATED CIRCUIT CONFERENCE, 20007. EUMIC 2007. EUROPEAN, IEEE, PI, 1 October 2007 (2007-10-01), pages 295-298, XP031197673 ISBN: 978-2-87487-002-6 * page 296, right-hand column; figures 3, 6 * | 1-14 | |
| X | MURY T ET AL: "2.4 GHz Class-E power amplifier with transmission-line harmonic terminations" 20070402, vol. 1, no. 2, 2 April 2007 (2007-04-02), pages 267-272, XP006028586 * page 267 - page 268; figure 6 * | 1-14 | TECHNICAL FIELDS SEARCHED (IPC) H03F |

-/--

The present search report has been drawn up for all claims

| Place of search | Date of completion of the search | Examiner |
|---|---|---|
| Munich | 11 December 2009 | Dietsche, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................................................

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

EP 09 36 0034

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CHOI Y-B ET AL: "Generalised frequency-domain analysis of microwave Class-E power amplifiers" IEE PROCEEDINGS: MICROWAVES, ANTENNAS AND PROPAGATION, IEE, STEVENAGE, HERTS, GB, vol. 148, no. 6, 3 December 2001 (2001-12-03), pages 403-409, XP006017857 ISSN: 1350-2417 * figure 8 * | 1-14 | |
| A | AFLAKI P ET AL: "Design and implementation of an inverse class-F power amplifier with 79 % efficiency by using a switch-based active device model" RADIO AND WIRELESS SYMPOSIUM, 2008 IEEE, IEEE, PISCATAWAY, NJ, USA, 22 January 2008 (2008-01-22), pages 423-426, XP031237189 ISBN: 978-1-4244-1462-8 * figure 2 * | 1-14 | |

TECHNICAL FIELDS
SEARCHED      (IPC)

The present search report has been drawn up for all claims

| Place of search | Date of completion of the search | Examiner |
|---|---|---|
| Munich | 11 December 2009 | Dietsche, Stefan |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

................................................................

& : member of the same patent family, corresponding
   document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6552210 B

**Non-patent literature cited in the description**

- **T. B. Mader ; Z. B. Popovic.** The Transmission-Line High-Efficiency Class-E Amplifier. *IEEE Microwave and Guided Wave Lett.,* September 1995, vol. 5, 290-292